# EUROPEAN PATENT APPLICATION

(11) **EP 4 668 517 A1**
(43) Date of publication of application: **24.12.2025**
(21) Application number: 24182897.9
(22) Date of filing: 18.06.2024
(51) Int. Cl.: H02H 9/04, H02H 9/08, H02H 3/16, G01R 31/52, H02H 7/16, H02H 7/18

(54) **ENERGY STORAGE DEVICE**

(71) Applicant: Hitachi Energy Ltd, 8050 Zürich (CH)
(72) Inventor: Zhang, Zichi, 723 58 Västerås (SE); Sahoo, Bikash, 756181 Bhadrak (IN); Söderblom, Anton, 749 43 Enköping (SE); Fan, JianZhong, 771 43 Ludvika (SE)
(74) Representative: AWA Sweden AB

(57) **Abstract**

An energy storage device is provided comprising a plurality of interconnected energy storage modules 102, an earthing busbar 104, and a protection unit 106. The protection unit comprises a resistor unit 108, a variable resistor unit 110 and a voltage detecting device 112. The variable resistor unit is connected in parallel to the resistor unit. The variable resistor unit is configured to change its resistance based on the voltage across the resistor unit. The voltage detecting device 112 is configured to detect a voltage deviation across the resistor unit and provide a feedback control signal to the energy storage device based on the detected voltage deviation. The protection unit is connected between the plurality of interconnected energy storage modules and the earthing busbar.

## Description

### Technical Field

The present disclosure relates to the field of energy storage systems (ESSs) in electric power systems configured to operate in and withstand high voltage potential. In particular, it relates to energy storage device in the energy storage system (ESS) comprising a protection unit for determining and controlling faults in the energy storage device.

### Background

The energy storage system (ESS) is an arrangement used to store energy. The energy storage system comprises one or more parallel connected energy strings. Each energy string may itself comprise one or more energy storage racks. Each of the energy storage racks may comprise several interconnected low-level energy storage modules, e.g. super capacitor modules, or battery modules. Each energy storage module may further comprise several energy storage cells, e.g. super capacitor cells, electrochemical/battery cells.

Different arrangements of the energy storage modules in the energy storage racks exist at present. A critical concern in such arrangements is a functional earthing, which is traditionally connected to an approximate midpoint of the voltage potential of the interconnected energy storage modules, leaving the entire energy storage rack at a floating voltage potential. Two primary faults can occur within these high-voltage energy storage racks, i.e. insulation faults within the energy storage modules and grounding faults of the rack itself. Insulation faults, for example, may arise due to electrolyte leakage from the super capacitor cells, leading to flashovers and insulation failure, which can result in severe consequences such as electric arcs, explosions, fires, electromagnetic interference, and signal disruptions. Grounding faults, on the other hand, are commonly caused by insulator aging of the energy storage racks which causes a dielectric breakdown between the functional earth and ground or falling conductive parts bridging the functional earth of the energy storage rack and the ground. The falling conductive parts can be for example, falling busbars or wires.

### Summary

Thus, it would be advantageous to achieve a method and a device to overcome, or at least alleviate, the above-mentioned drawbacks. In particular, it would be desirable to enable efficient grounding system design that aims to mitigate these risks. To better address one or more of these concerns, an energy storage device having the features defined in the independent claims are provided. Preferable embodiments are defined in the dependent claims.

Hence, according to an aspect, an energy storage device is provided comprising a support structure, a plurality of interconnected energy storage modules, an earthing busbar, and a protection unit. The plurality of interconnected energy storage modules are supported by the support structure. The earthing busbar is connected with the support structure. The earthing busbar may provide a reference voltage potential. The protection unit comprises a resistor unit, a variable resistor unit and a voltage detecting device. The variable resistor unit is connected in parallel to the resistor unit. The variable resistor unit is configured to change its resistance based on the voltage across the resistor unit. The voltage detecting device is configured to detect a voltage deviation across the resistor unit and provide a feedback control signal to the energy storage device based on the detected voltage deviation. The voltage deviation across the resistor unit may be substantially zero or insignificant in the absence of a fault. The protection unit is connected between the plurality of interconnected energy storage modules and the earthing busbar.

The variable resistor unit may be normally configured to provide high resistance. However, the resistance of the variable resistor unit may decrease when the voltage across the resistor unit increases. The variable resistor unit may be configured to limit voltage drop across the resistor unit by bypassing an increased current when the voltage drop across the resistor unit reaches a threshold value of the variable resistor unit. Therefore, the variable resistor unit would help in limiting the voltage drop from increasing across the resistor unit above the threshold value of the variable resistor unit. The threshold value is a voltage threshold of the variable resistor unit at which the resistance of the variable resistor unit may decrease significantly. The decreased resistance would allow the increased current or fault current to flow through the variable resistor unit instead of the resistor unit. Thus, safeguarding the resistor unit from being burnt out.

An advantage associated with the present disclosure is that the protection unit, that comprises the resistor unit, the variable resistor, and the voltage detecting device to detect insulation failures, facilitates the design of an efficient grounding system for the energy storage device. This enhances the reliability and safety of the present energy storage devices, such as the above-mentioned energy storage racks, without necessitating significant alterations to existing rack configurations.

A chassis of at least one energy storage module of said plurality of interconnected energy storage modules may be configured to be connected to the earthing busbar. The earthing busbar may provide a reference voltage potential to the at least one energy storage module of said plurality of interconnected energy storage modules.

The protection unit which comprises the resistor unit may be configured to provide a high impedance current path.

An advantage associated with having the high impedance current path for fault currents via the resistor unit is that it may prevent the increased fault current from passing through the resistor unit. This may help preventing burn-out of the resistor unit.

The energy storage device may further comprise an auxiliary ground connected to the earthing busbar.

The plurality of interconnected energy storage modules in the energy storage device may comprise of capacitor modules, or battery modules, or a combination thereof.

The capacitor module may be a combination of plurality of capacitor cells. For instance, the capacitor module may be either a 6S2P capacitor module, 4S2P capacitor module, or a combination.

The variable resistor unit may comprise a metal-oxide varistor (MOV). The resistance of the MOV may decrease as the voltage across the resistor unit increases. The MOV may limit the voltage drop across the resistor unit by bypassing increased current across the resistor unit.

The voltage detecting device may comprise a voltage transducer. The voltage transducer may detect a voltage deviation across the resistor unit and provide a feedback control signal to the energy storage device based on the detected voltage deviation.

The energy storage device may be configured to operate in and withstand high voltage potential.

The resistor unit in the protection unit may comprise two or more resistors. The two or more resistors in the resistor unit may be connected in series to each other.

The voltage detecting device may comprise a number of voltage transducers corresponding to the number of resistors of the resistor unit. Each resistor may be connected in parallel to a respective voltage transducer of the voltage transducers.

The protection unit may be connected to a middle point of voltage potential of the energy storage device.

The term middle point may be defined as a point within the energy storage device that approximately divides the potential equally between the positive terminal of the energy storage device and the middle point, and between the potential across the negative terminal of the energy storage device and the middle point.

The variable resistor unit may be a surge arrester. The surge arrester may be configured to detect a sudden surge in the voltage across the resistor unit caused by a sudden increase in current, for example fault current, passing through the resistor unit. As soon as the voltage across the resistor unit reaches a threshold value of the surge arrester, the surge arrester will bypass the increased current from the surge arrester instead of the resistor unit. Thereby, the surge arrester would help in limiting the voltage from increasing across the resistor unit. The surge arrester is configured to decrease its resistance significantly when the voltage across the surge arrester reaches the threshold value.

### Brief description of the drawings

These and other aspects will now be described in more detail with reference to the appended drawings showing embodiments.
Figure 1 schematically shows a basic structure of an energy storage device comprising a protection unit;
Figure 2 schematically shows an alternative structural design of the protection unit;
Figure 3 schematically shows another exemplary embodiment structure of an energy storage device comprising a protection unit;
Figure 4 schematically shows yet another exemplary embodiment structure of an energy storage device comprising a plurality of protection units.

All the figures are schematic, not necessarily to scale, and generally only show parts which are necessary in order to elucidate the embodiments, wherein other parts may be omitted or merely suggested. Like reference numerals refer to like elements throughout the description.

### Detailed description

The present aspects will now be described more fully hereinafter with reference to the accompanying drawings, in which currently preferred embodiments are shown. These aspects may, however, be embodied in many different forms and should not be construed as limited to the embodiments set forth herein; rather, these embodiments are provided for thoroughness and completeness, and fully convey the scope of the present aspects to those skilled in art.

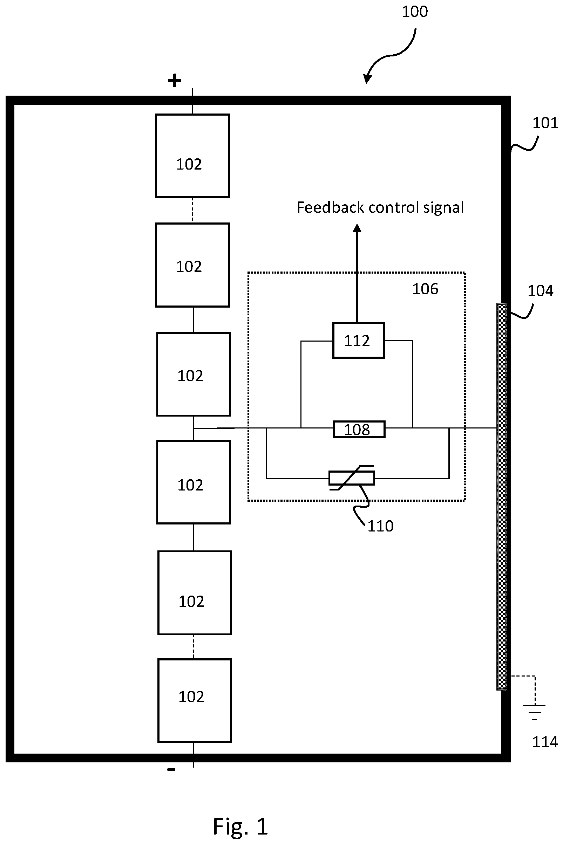

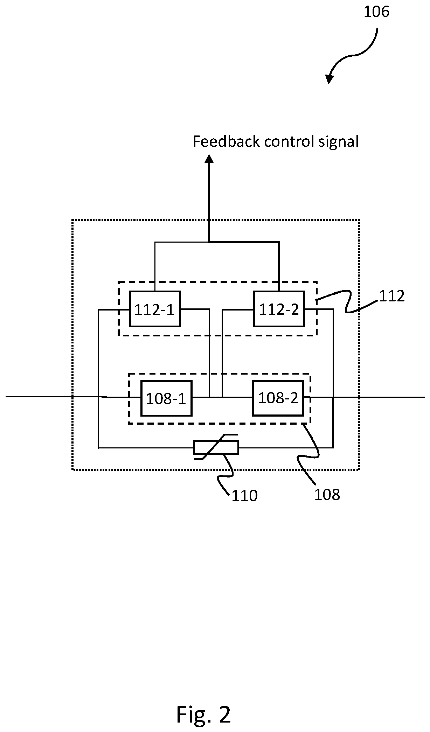

Referring to figure 1, according to an embodiment thereof an energy storage device 100 comprises a support structure 101, a plurality of interconnected energy storage modules 102, an earthing busbar 104, and a protection unit 106. The plurality of interconnected energy storage modules 102 are supported by the support structure 101. The support structure 101 encloses the plurality of interconnected energy storage modules 102. The earthing busbar 104 is configured to be connected with the support structure 101. The earthing busbar 104 may provide a reference voltage potential. The protection unit 106 comprises a resistor unit 108, a variable resistor unit 110 and a voltage detecting device 112. The resistor unit 108 may comprise one or more resistors. The voltage detecting device 112 may comprise one or more voltage transducers. A detailed example of the protection unit 106 is explained later with reference to figure 2. One end of the energy storage device 100 is configured to be connected to a positive supply voltage while another end of the energy storage device 100 is configured to be connected to the negative supply voltage. The variable resistor unit 110 is connected in parallel to the resistor unit 108.

The variable resistor unit 110 is configured to change its resistance based on the voltage across the resistor unit 108. The voltage detecting device 112 is configured to detect a voltage deviation across the resistor unit 108 and provide a feedback control signal to the energy storage device 100 based on the detected voltage deviation. The voltage deviation across the resistor unit 108 may be substantially zero or insignificant in the absence of a fault. The protection unit 106 is connected between the plurality of interconnected energy storage modules 102 and the earthing busbar 104. A plurality of energy storage devices 100 may be interconnected to form a whole energy storage system (ESS).

For instance, in case of a ground fault in the energy storage device 100 which causes dielectric breakdown between the earthing busbar 104 and ground, the current flowing through the resistor unit 108 may increase causing the voltage deviation across the resistor unit 108. The voltage detecting device 112 is configured to detect a voltage deviation across the resistor unit 108 and provide a feedback control signal to the energy storage device 100 based on the detected voltage deviation. While at the same time the variable resistor unit 110 connected in parallel to the resistor unit 108 is configured to decrease its resistance based on the increased voltage drop across the resistor unit 108. The variable resistor unit 110 may decrease its resistance when the voltage drop across the resistor unit 108 reaches a threshold of the variable resistor unit 110. The decreased resistance of the variable resistor unit 110 allows a significant portion of the increased current to flow through the variable resistor unit 110 instead of the resistor unit 108. Thereby, resisting significant voltage increase across the resistor unit 108. This prevents the resistor unit 108 from being burned and enhances the reliability and safety of the energy storage devices 100 in an energy storage system.

In the case of the insulation fault within the energy storage modules 102, the internal leakage may be controlled by the resistor unit 108 itself. The resistor unit 108 may pass the current through it directly to the earthing busbar 104. The insulation fault may not cause a significant increase in fault current. Therefore, the voltage drop across the resistor unit 108 may not reach or surpass the threshold value of the variable resistor unit 110. As a result, the variable resistor unit 110 may not be activated to bypass the current flowing through the resistor unit 108. However, the voltage detecting device 112 is configured to work as described above. That is, the voltage detecting device 112 may detect a voltage deviation across the resistor unit 108 and provide a feedback control signal to the energy storage device 100 based on the detected voltage deviation.

The protection unit 106 is connected to a middle point of voltage potential of the energy storage device 100. The middle point is a point which divides the potential across the energy storage device 100 in two equal parts. In other words, the amount of voltage stored in the number of energy storage modules 102 in the energy storage device 100 is equally distributed on either side of the middle point. However, it is possible to have the protection unit 106 connected to a point that is other than the point which is at the middle of the energy storage device 100 compring the plurality of interconnected energy storage modules 102.

The energy storage device 100 may further comprise an auxiliary ground 114 connected to the earthing busbar 104.

According to an embodiment of the protection unit 106, as shown in figure 2 the protection unit 106 comprises a resistor unit 108, a variable resistor unit 110 and a voltage detecting device 112. The resistor unit 108 comprises two resistors 108-1, 108-2. The two resistors 108-1, 108-2 in the resistor unit 108 are connected in series to each other. The voltage detecting device 112 comprises two voltage transducers 112-1, 112-2, corresponding to the number of resistors of the resistor unit 108. Each resistor is connected in parallel to a respective voltage transducer of the voltage transducers 112-1, 112-2. Each voltage transducer of the voltage transducers 112-1, 112-2 is configured to detect any voltage deviation across the corresponding resistor 108-1, 108-2 of the resistor unit 108.

The two resistors 108-1, 108-2 in the resistor unit 108 are connected in series to each other. However, the person skilled in the art would understand that the resistor unit 108 may comprise any number of resistors 108-1, 108-2,... 108-n. Similarly, the voltage detecting device 112 may comprise a number of voltage transducers 112-1, 112-2,... , 112-n. Each resistor 108-1, 108-2,... 108-n may be connected in parallel to a respective voltage transducer of the voltage detecting device 112-1, 112-2,... , 112-n.

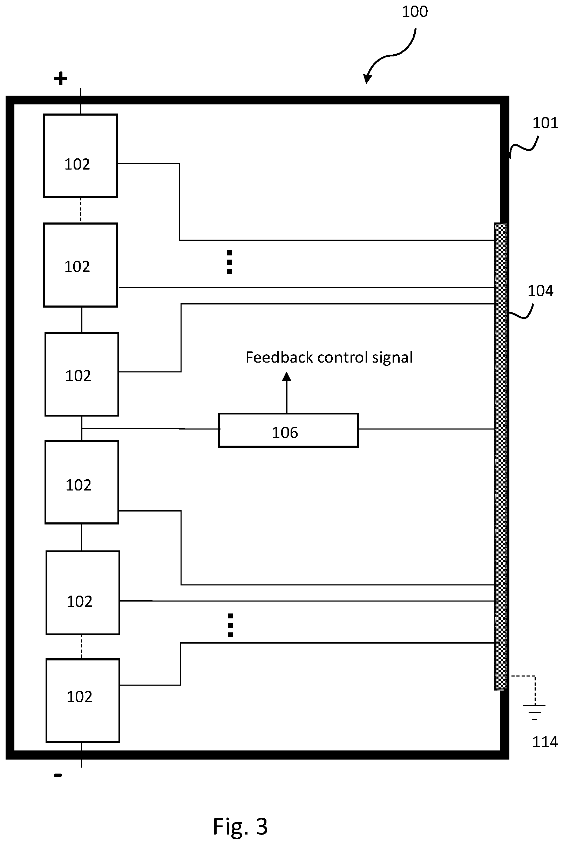

According to another exemplary embodiment of an energy storage device 100 comprising the protection unit 106, as shown in figure 3, a major part of the energy storage device 100 is similar to that shown in figure 1. Additionally, the energy storage device 100 comprises a chassis of the energy storage module of the plurality of interconnected energy storage modules 102 configured to be connected to the earthing busbar 104.

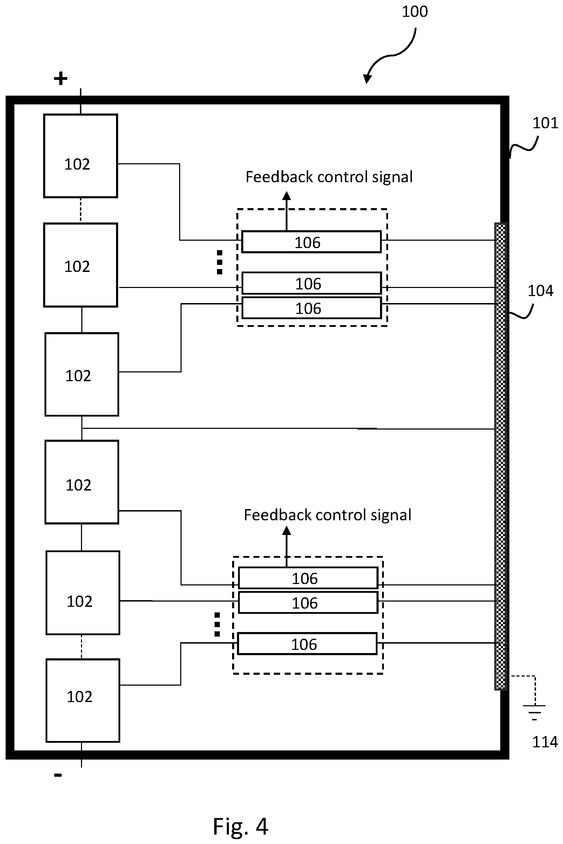

According to another exemplary embodiment of an energy storage device 100 comprising the protection unit 106, as shown in figure 4, the energy storage device 100 is similar to that discussed earlier in figure 3. However, the energy storage device 100 comprises a plurality of protection units 106 instead of a single protection unit 106 as shown in figure 2. Further, each protection unit of the plurality of protection units 106 is configured to be connected between the chassis of the energy storage module of the plurality of interconnected energy storage modules 102 and the earthing busbar 104. The plurality of interconnected energy storage modules 102 is configured to be connected directly at the middle point to the earthing busbar 104. At least one voltage detecting device 112 of the voltage detecting devices 112 of each of the protection units 106 may detect a voltage deviation across the corresponding resistor units 108 and provide a feedback control signal to the energy storage device 100 based on the detected voltage deviation.

The feedback control signal may be provided from each of the protection units 106 to the energy storage device 100 independently or as a consolidated feedback signal.

While the present disclosure has been illustrated and described in detail in the drawings and foregoing description, such illustration and description are to be considered illustrative or exemplary and not restrictive.

Although features and elements are described above in particular combinations, each feature or element can be used alone without the other features and elements or in various combinations with or without other features and elements.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain features are recited in mutually different dependent claims does not indicate that a combination of these features cannot be used to advantage. Any reference signs in the claims should not be construed as limiting the scope.

## Claims

1. An energy storage device (100) comprising:
a support structure (101);
a plurality of interconnected energy storage modules (102) supported by the support structure;
an earthing busbar (104) connected with the support structure;
a protection unit (106), wherein the protection unit comprises a resistor unit (108);
a variable resistor unit (110) connected in parallel to the resistor unit,
wherein the variable resistor unit is configured to change its resistance based on the voltage across the resistor unit; and
a voltage detecting device (112), wherein the voltage detecting device is configured to detect a voltage deviation across the resistor unit and
provide a feedback control signal to the energy storage device based on the detected voltage deviation;
wherein the protection unit is connected between the plurality of interconnected energy storage modules and the earthing busbar.

2. The energy storage device according to claim 1, wherein a chassis of at least one energy storage module of said plurality of interconnected energy storage modules is connected to the earthing busbar.

3. The energy storage device according to any one of claims 1 and 2, wherein the resistor unit provides a high impedance current path.

4. The energy storage device according to any one of claims 1-3, wherein the energy storage device further comprises an auxiliary ground (114) connected to the earthing busbar.

5. The energy storage device according to any one of claims 1-4, wherein the plurality of interconnected energy storage modules comprises capacitor modules or battery modules.

6. The energy storage device according to claim 5, wherein the capacitor module is a combination of plurality of capacitor cells.

7. The energy storage device according to any one of claims 1-6, wherein the variable resistor unit comprises a metal-oxide varistor, MOV.

8. The energy storage device according to any one of claims 1-7, the voltage detecting device comprises a voltage transducer.

9. The energy storage device according to any one of claims 1-8, being configured to operate in and withstand high voltage potential.

10. The energy storage device according to any one of claims 1-9, wherein the resistor unit comprises two or more resistors.

11. The energy storage device according to claim 10, wherein the voltage detecting device comprises a number of voltage transducers corresponding to the number of resistors of the resistor unit, wherein each resistor is connected in parallel to a respective voltage transducer of the voltage transducers.

12. The energy storage device according to claims 1-11, wherein the protection unit is connected to a middle point of voltage potential of the energy storage device.

13. The energy storage device according to claims 1-12, wherein the variable resistor unit is a surge arrester.
